# EUROPEAN PATENT APPLICATION

(11) **EP 2 645 425 A1**
(43) Date of publication of application: **02.10.2013**
(21) Application number: 13161340.8
(22) Date of filing: 27.03.2013
(51) Int. Cl.: H01L 31/042, H01L 31/05

(54) **System for distributing electrical power supplied from a solar panel array**

(30) Priority: 27.03.2012 US 201213431366
(71) Applicant: General Electric Company, Schenectady, New York 12345 (US)
(72) Inventor: Tagliamonte, Efrem, Schenectady, NY New York 12345 (US)
(74) Representative: Picker, Madeline Margaret

(57) **Abstract**

A system for distributing electrical power supplied from a plurality of solar panels 12 supported by a racking assembly 14 is disclosed. The system may generally include a supply line 102 extending along a length of the racking assembly and a plurality of mounting modules 128 spaced apart along the length of the racking assembly. The supply line may include a positive supply conductor 106 and a negative supply conductor 108. Each of the mounting modules may be configured to receive the positive and negative supply conductors such that the positive supply conductor is spaced apart from the negative supply conductor. The system may also include a positive feed conductor 110 electrically connected to the plurality of solar panels and a negative feed conductor 112 electrically connected to the plurality of solar panels. In addition, the system may include a first splice terminal 114 configured to electrically connect the positive feed conductor to the positive supply conductor and a second splice terminal 116 configured to electrically connect the negative feed conductor to the negative supply conductor.

## Description

The present subject matter relates generally to solar panel arrays and, more particularly, to a system for distributing electrical power supplied from an array of solar panels supported by a racking assembly.

Solar power is considered one of the cleanest, most environmentally friendly energy sources presently available, and solar panel arrays have gained increased attention in this regard. Typically, the direct current (DC) power output generated by solar panels is transmitted via a wiring system to a power convertor or other power conversion device. This power conversion device converts the DC power output to an alternating current (AC) power output that may be supplied to a utility grid.

Conventional wiring methods for solar panel arrays typically require that each solar panel be individually wired to a single circuit fuse. This results in excessive lengths of conductors being utilized to connect each solar panel to the circuit fuse, thereby increasing the overall cost of the solar panel array. Such individual wiring also increases the complexity of installing the solar panel array. Moreover, due to the excessive conductor lengths, it is often difficult to affix the conductors to the racking assembly of the solar panel array in a clean, safe and/or efficient manner.

Accordingly, a system for distributing the electrical power supplied from a solar panel array that reduces the required lengths of the conductors and/or that simplifies the installation and/or the wire management of the conductors would be welcomed in the technology.

Aspects and advantages of the invention will be set forth in part in the following description, or may be obvious from the description, or may be learned through practice of the invention.

In one aspect, the present subject matter is directed to a system for distributing electrical power supplied from a plurality of solar panels supported by a racking assembly. The system may generally include a supply line extending along a length of the racking assembly and a plurality of mounting modules spaced apart along the length of the racking assembly. The supply line may include a positive supply conductor and a negative supply conductor. Each of the mounting modules may be configured to receive the positive and negative supply conductors such that the positive supply conductor is spaced apart from the negative supply conductor. The system may also include a positive feed conductor electrically connected to the plurality of solar panels and a negative feed conductor electrically connected to the plurality of solar panels. In addition, the system may include a first splice terminal configured to electrically connect the positive feed conductor to the positive supply conductor and a second splice terminal configured to electrically connect the negative feed conductor to the negative supply conductor.

In another aspect, the present subject matter is directed to a solar panel array. The solar panel array may generally include a racking assembly having a plurality of lengthwise rails and a plurality of crosswise rails. The solar panel array may also include a plurality of solar panels supported by the racking assembly, with each solar panel including a positive output conductor and a negative output conductor. In addition, the solar panel array may include a supply line extending along a length of a first lengthwise rail of the lengthwise rail and a plurality of mounting modules mounted to the first lengthwise rail. The supply line may include a positive supply conductor and a negative supply conductor. Each of the mounting modules may be configured to receive the positive and negative supply conductors such that the positive supply conductor is spaced apart from the negative supply conductor. Moreover, the solar panel array may also include a positive feed conductor electrically connected to the positive output conductor of each of the solar panels and a negative feed conductor electrically connected to the negative output conductor of each of the solar panels. Further, the solar panel array may include a first splice terminal configured to electrically connect the positive feed conductor to the positive supply conductor and a second splice terminal configured to electrically connect the negative feed conductor to the negative supply conductor.

In a further aspect, the present subject matter is directed to a solar farm including a plurality of solar panel arrays. Each of the solar panel arrays may include a racking assembly and a plurality of solar panels supported by the racking assembly. Each of the solar panels may include a positive output conductor and a negative output conductor. In addition, the solar farm may include a supply line extending along a length of each of the solar panel arrays. The supply line may include a positive supply conductor and a negative supply conductor. The positive output conductor of each of the solar panels may be electrically connected to the positive supply conductor and the negative output conductor of each of the solar panels may be electrically connected to the negative supply conductor.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

A full and enabling disclosure of the present invention, including the best mode thereof, directed to one of ordinary skill in the art, is set forth in the specification, which makes reference to the appended figures, in which:
FIG. 1 illustrates a perspective view of one embodiment of a solar panel array in accordance with aspects of the present subject matter;
FIG. 2 illustrates a simplified, schematic view of one embodiment of a system for distributing electrical power supplied from a solar panel array in accordance with aspects of the present subject matter;
FIG. 3 illustrates a perspective view of one embodiment of how various components of the system shown in FIG. 2 may be installed onto a racking assembly of a solar panel array, particularly illustrating a rear, perspective view of a portion of the racking assembly with the solar panels removed;
FIG. 4 illustrates a perspective view of one embodiment of a splice terminal configuration that may be utilized with the system shown in FIGS. 2 and 3, particularly illustrating a housing exploded away from the splice terminal;
FIG. 5 illustrates a cross-sectional view of the assembled housing shown in FIG. 4, particularly illustrating a filler material surrounding the conductors and the splice terminal housed therein; and
FIG. 6 illustrates a perspective, exploded view of one embodiment of a mounting module configuration that may be utilized with the system shown in FIGS. 2 and 3.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment can be used with another embodiment to yield a still further embodiment. Thus, it is intended that the present invention covers such modifications and variations as come within the scope of the appended claims and their equivalents.

In general, the present subject matter is directed to a system for distributing electrical power supplied from an array of solar panels supported by a racking assembly. Specifically, in several embodiments, the system may include a supply line configured to be coupled along the length of one of the rails of the racking assembly. For instance, a plurality of mounting modules may be mounted to a lengthwise rail of the racking assembly and may be configured to receive the conductors of the supply line. In addition, the output conductors of the solar panels may be electrically connected to common feed conductors that may, in turn, be electrically connected to the conductors of the supply line. For example, in one embodiment, a splice terminal may be utilized to electrically connect that feed conductors to the conductors of the supply line.

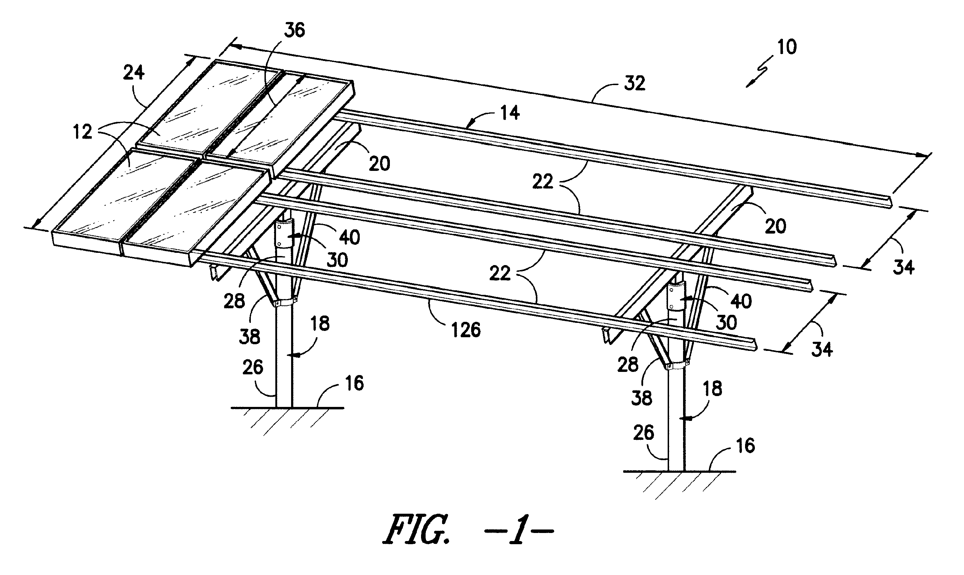

Referring now to the drawings, FIG. 1 illustrates a perspective view of one embodiment of a solar panel array 10. As shown, the solar panel array 10 includes a plurality of solar panels 12 coupled to a racking assembly 14 that is supported above a support surface 16 via a one or more support posts 18. It should be appreciated that solar panel array 10 has been shown with only a few solar panels 12 installed thereon in order to illustrate various other components of the solar panel array 10.

In general, the solar panels 12 may comprise any suitable photovoltaic (PV) devices known in the art for converting solar energy into a direct current (DC) electrical power output. For instance, suitable PV devices may include, but are not limited to, crystalline silicon modules and thin-film PV devices, such as Si-based PV devices, CdTe-based PV devices, CIGS-based PV devices and/or the like.

The racking assembly 14 of the solar panel array 10 may generally be configured to support the solar panels 12 above the support surface 16. Thus, it should be appreciated that the racking assembly 14 may generally include any number and/or combination of rails, beams and/or other suitable support members that permit the racking assembly 14 to function as described herein. For instance, as shown in the illustrated embodiment, the racking assembly 14 includes a plurality of interconnected rails 20, 22, such as one or more crosswise rails 20 and one or more lengthwise rails 22.

In several embodiments, each crosswise rail 20 of the racking assembly 14 may be configured to extend longitudinally along a width 24 of the solar panel array 10. In addition, each crosswise rail 20 may be configured to be coupled to one of the support posts 18. For instance, as shown in FIG. 1, each support post 18 may extend longitudinally between a first end 26 and a second end 28, with the first end 26 being coupled to the support surface 16 and the second end 28 being coupled to one of the crosswise rails 20.

It should be appreciated that the crosswise rails 20 may be coupled to the support posts 18 using any suitable attachment means and/or method known in the art. For instance, as shown in FIG. 1, the crosswise rails 20 may be indirectly coupled to the support posts 18, such as by securing a rack support coupling 30 between each crosswise rail 20 and the second end 28 of each support post 18. Alternatively, the crosswise rails 20 may be directly coupled to the support posts 18, such as by mounting each crosswise rail 20 directly to the second end 28 of each support post 18 using suitable mechanical fasteners (e.g., screws, bolts, pins, brackets and/or the like) or by welding each crosswise rail 20 to the second end 28 of each support post 18. Similarly, the first end 26 of each support post 18 may be configured to be coupled to the support surface 16 using any suitable means and/or method known in the art. For instance, in embodiments in which the support surface 16 comprises the ground, the first end 26 of each support post 18 may simply be driven into the ground a suitable depth. Alternatively, in embodiments in which the support surface 16 comprises a concrete pad or other suitable hard-drying material, the first end 26 of each support post 18 may be encased within the concrete or other suitable material in order to couple the support post 18 to the support surface 16.

In addition, the lengthwise rails 22 of the racking assembly 20 may be configured to be coupled to the crosswise rails 20 so as to extend longitudinally along a length 32 of the solar panel array 10. For instance, as shown in FIG. l, the lengthwise rails 22 may be coupled across the crosswise rails 20 such that the lengthwise rails 22 extend generally perpendicular to the crosswise rails 20. It should be appreciated that the lengthwise rails 22 may be coupled to the crosswise rails 20 using any suitable means and/or method known art, such as by coupling the lengthwise rails 22 to the crosswise rails 20 using suitable mechanical fasteners and/or by welding the lengthwise rails 22 to the crosswise rails 20.

Moreover, the lengthwise rails 22 may also be configured to be spaced apart from one another along the width 24 of the solar panel array 10 so as to provide a means for coupling the solar panels 12 to the racking assembly 14. For example, as shown in FIG. 1, in one embodiment, the racking assembly 14 may include two pairs of lengthwise rails 22 for mounting two rows of solar panels 12 across the assembly 14. In such an embodiment, the lengthwise rails 22 in each pair may generally being spaced apart from one another a distance 34 that is generally equal to or less than a width 36 of each solar panel 12. However, it should be appreciated that, in alternative embodiments, the racking assembly 14 may include any other number of lengthwise rails 22 for mounting any suitable number of rows of solar panels 12 across the assembly 14.

Additionally, in several embodiments, the racking assembly 14 may also include one or more support arms 38, 40 coupled between each support post 18 and one or more of the rails 20, 22 of the assembly 14. For example, as shown in the illustrated embodiment, the racking assembly 14 may include first and second support arms 38, 40 extending between each cross-wise rail 20 and its corresponding support post 18. The support arms 38, 40, together with the support posts 18, may generally be configured to provide vertical support for the racking assembly 14 and, thus, the solar panels 12.

It should be appreciated that the racking assembly 14 shown in FIG. 1 is merely illustrated to provide one example of how such an assembly may be configured for supporting a plurality solar panels 12. Thus, one of ordinary skill in the art should readily appreciate that the present subject matter need not be limited to any particular racking assembly configuration.

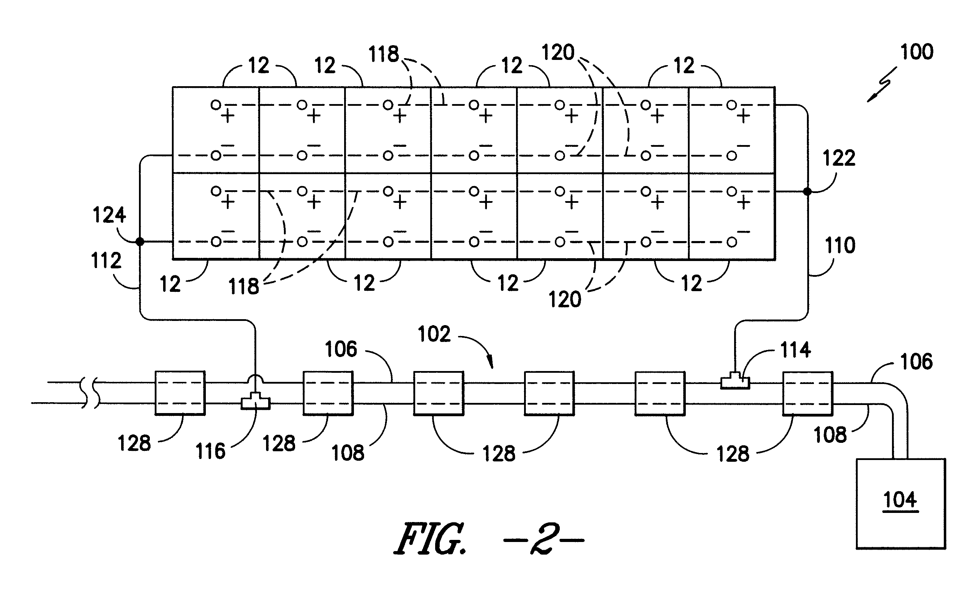

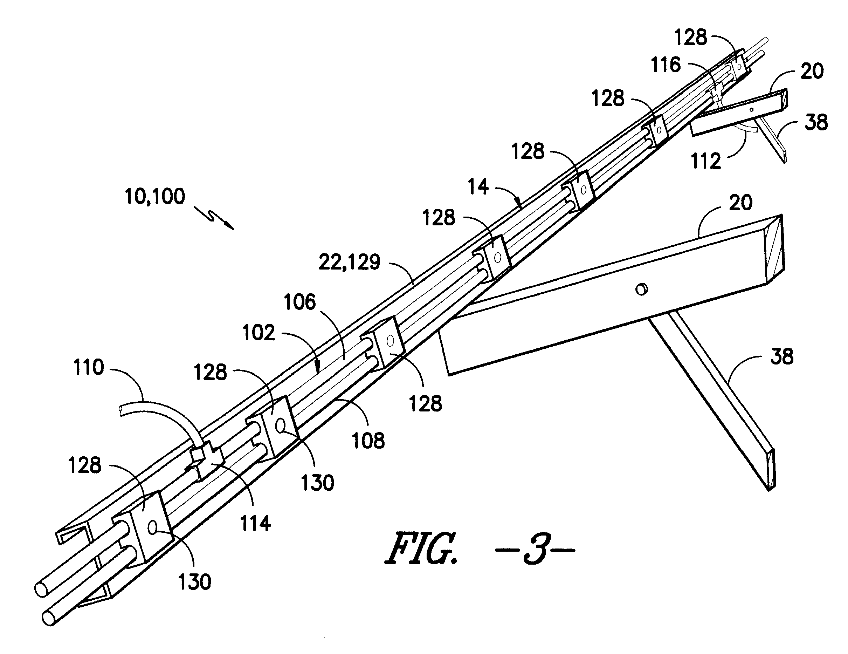

Referring now to FIGS. 2 and 3, one embodiment of a system 100 that may be utilized with a solar panel array 10 to distribute the electrical power generated by the solar panels 12 is illustrated in accordance with aspects of the present subject matter. In particular, FIG. 2 illustrates a simplified, schematic view of the system 100. In addition, FIG. 3 illustrates a perspective view of one embodiment of how various components of the system 100 may be installed onto the racking assembly 14 shown in FIG. l, particularly illustrating a rear, perspective view of a portion of the racking assembly 14 with the solar panels 12 removed.

As shown in FIG. 2, the system 100 may generally include a supply line 102 configured to transmit the DC power output of the solar panels 12 to a power conversion device 104 for converting the output to an alternating current (AC) power output. For example, the supply line 102 may include a positive supply conductor 106 and a negative supply conductor 108 electrically connected to the power conversion device 104. In addition, the system may include at least two feed conductors 110, 112 electrically connected between the solar panels 12 and the supply line 102. For instance, as shown in FIG. 2, the system 100 may include a positive feed conductor 110 electrically connected to the positive supply conductor 106 via a first splice terminal 114 and a negative feed conductor 112 electrically connected to the negative supply conductor 108 via a second splice terminal 116. The feed conductors 110, 112 may, in turn, be electrically connected to corresponding output conductors 118, 120 of the solar panels 12. For example, as shown in the illustrated embodiment, each solar panel 12 may include a positive output conductor 118 and a negative output conductor 120. Thus, in several embodiments, the positive output conductors 118 of the solar panels 12 may be electrically connected to the positive feed conductor 110 at a first common node 112 (e.g., by using a suitable wire harness) and the negative output conductors 120 of the solar panels 12 may be electrically connected to the negative feed conductor 112 at a second common node 124 (e.g., by using a suitable wire harness). Accordingly, the DC power output of each solar panel 12 may be transmitted by the feed conductors 110, 112 to the supply line 102 via the splice terminals 114, 116 for delivery to the power conversion device 104.

It should be appreciated that, as used herein, the term "conductor" refers to any length of conductive material that is capable of transferring electric charges. As such, the term "conductor" may encompass wires having an insulating material surrounding the conductive material.

It should also be appreciated that, although the embodiment of the system 100 illustrated in FIG. 2 shows an array of fourteen solar panels 12 electrically connected at the common nodes 122, 124, any number of solar panels 12 may generally be grouped together in a solar panel array 10 and electrically connected at the common nodes 122, 124. For instance, the disclosed system 100 may include less than fourteen solar panels 12 grouped together, such as an array of two or more solar panels 12, or greater than fourteen solar panels. In addition, any number of solar panel arrays 10 may be electrically connected to the supply line 102. For example, in one embodiment, a plurality of solar panel arrays 10 (forming all or part of a solar farm) may be spaced apart along the length of the supply line 102. In such an embodiment, each solar panel array 10 may include feed conductors 110, 112 electrically connected to the supply line 102 via suitable splice terminals 114, 116.

In several embodiments, the supply line 102 may be configured to extend along the entire length 32 of each solar panel array 10. For instance, as shown in the illustrated embodiment, the supply line 102 may be configured extend along the entire length 32 of the racking assembly 14. In such an embodiment, the supply line 102 may be coupled to one of the lengthwise rails 22 of the racking assembly 14 in order to support the positive and negative supply conductors 106, 108 above the support surface 16. For example, as particularly shown in the partial perspective view of FIG. 3, the supply line 102 may be coupled to a front lengthwise rail 126 of the racking assembly 14 (also labeled in FIG. 1), such as by being coupled to the back-side of the front lengthwise rail 126. However, in other embodiments, the supply line 102 may be coupled to any other lengthwise rail(s) 22 of the racking assembly 14 and/or to one or more of the crosswise rails 20 of the racking assembly 14.

It should be appreciated that that the supply line 102 may be coupled to one or more of the rails 20, 22 of the racking assembly 14 using any suitable means known in the art. For example, in several embodiments, the supply line 102 may be coupled to the rail(s) 20, 22 of the racking assembly 14 using tie-downs, rope, hooks, eyelets and/or any other suitable connectors. However, in a particular embodiment of the present subject matter, the supply line 102 may be coupled to the rail(s) 20, 22 using a plurality of mounting modules 128. For example, as shown in FIG. 3, a plurality of mounting modules 128 may be spaced apart along the length of the front lengthwise rail 126, with each mounting module 128 being individually mounted to the rail 126. In such an embodiment, each of the mounting modules 126 may be configured to receive the positive and negative supply conductors 106, 108 of the supply line 102 so that the positive supply conductor 106 is spaced apart or otherwise separated from the negative supply conductor 108 within the mounting module 128.

It should also be appreciated that the mounting modules 128 may be configured to be mounted to the rail(s) 20, 22 of the racking assembly 14 using any suitable attachment means and/or method known in the art. For example, as shown in FIG. 3, in one embodiment, each mounting module 128 may be mounted to the front lengthwise rail 126 using one or more mechanical fasteners 130, such as one or more bolts, screws, brackets, pins and/or the like. In another embodiment, the mounting modules 128 may be welded to the front lengthwise rail 126 and/or the mounting modules 128 may be adhered to the front lengthwise rail 126 using a suitable adhesive.

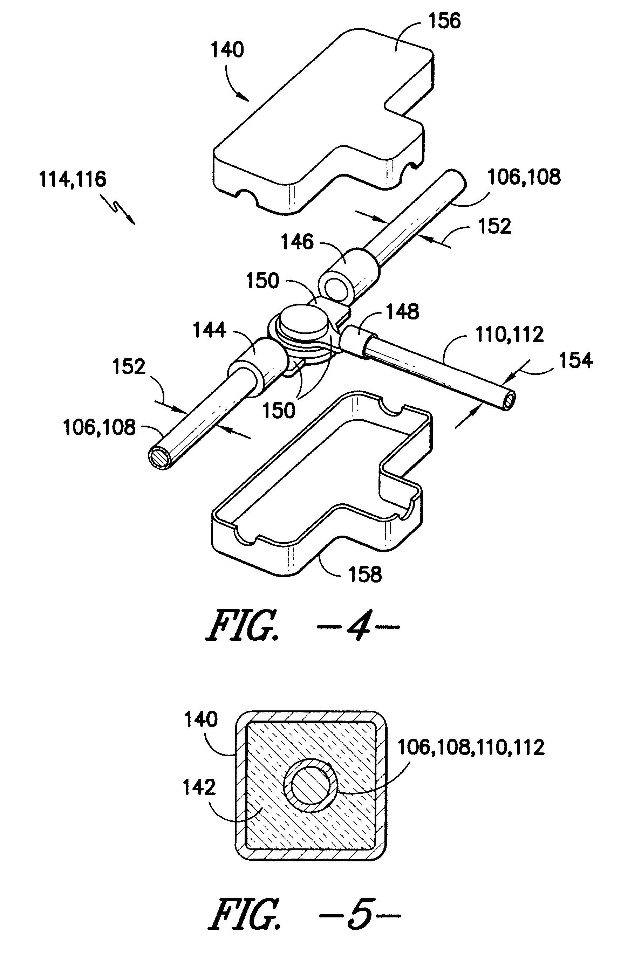

Referring now to FIGS. 4 and 5, one embodiment of a suitable splice terminal configuration that may be used for the first and second splice terminals 114, 116 described above with reference to FIGS. 2 and 3 is illustrated in accordance with aspects of the present subject matter. In particular, FIG. 4 illustrates a perspective view of the splice terminal 114, 116, particularly illustrating a housing 140 exploded away from the splice terminal 114, 116. In addition, FIG. 5 illustrates a cross-sectional view of the assembled housing 140 shown in FIG. 4, particularly illustrating a filler material 142 surrounding the splice terminal 114, 116 housed therein.

As particularly shown in FIG. 4, in several embodiments, the splice terminal 114, 116 may be comprise as a three-way splice terminal and, thus may include three separate connectors 144, 146, 148 for receiving the spliced conductors 106, 108, 110, 112. For example, as shown in the illustrated embodiment, the splice terminal 114, 116 may include first and second barrel connectors 144, 146 configured to receive opposed ends of one of the supply conductors 106, 108 (i.e., opposed ends of the positive supply conductor 106 or the negative supply conductor 108). In addition, the splice terminal 114, 116 may include a third barrel connector 148 for receiving the end of the feed conductor 110, 112 being spliced into the supply line 102 (i.e., the end of the positive feed conductor 110 or the negative feed conductor 12). As is generally understood, the connectors 144, 146, 148 may be in electrical contact with one another such that the electrical power carried through the feed conductor 110, 112 may be transmitted to the supply conductor 106, 108 via the splice terminal 114, 116. For example, as shown in the illustrated embodiment, each connector 144, 146, 148 may include a tongue 150 (e.g., a ring tongue) configured to be in electrical contact with the tongues 150 of the other connectors 144, 146, 148, such as by coupling the tongues 150 to one another using a suitable mechanical fastener. Alternatively, the connectors 144, 146, 148 may by integrally formed on and/or mounted to a common tongue 150.

It should be appreciated that, in alternative embodiments, the splice terminal 114, 116 may have any other suitable configuration that permits it to function as described herein. For instance, in another embodiment, the splice terminal 114, 116 may include any other suitable type of connectors 144, 146, 148 and/or tongue(s) 150. In addition, it should be appreciated that the splice terminal 114, 116 need not be comprise a three-way splice terminal. For instance, in one embodiment, the splice terminal 114, 116 may be comprise a two-way splice terminal, such as by configuring the splice terminal 114, 116 such that it splices the feed conductor 110, 112 into a continuous supply conductor 106, 108.

It should also be appreciated that, in several embodiments, the conductors 106, 108, 110, 112 being spliced at the splice terminal 114, 116 may be formed from dissimilar materials and/or may define dissimilar cross-sectional areas. For instance, the supply conductors 106, 108 may be formed from a different material than the feed conductors 110, 112. Specifically, in one embodiment, it may be desirable to form the supply conductors 106, 108 from aluminum and the feed conductors 110, 112 from copper, thereby reducing the overall cost of the solar panel array 10. Additionally, in several embodiments, the supply conductors 106, 108 may have a larger cross-sectional area than the feed conductors 110, 112 at the splice terminal 114, 116. For instance, as shown in FIG. 4, the supply conductor 106, 108 may define a diameter 152 that is larger than a diameter 154 of the feed conductor 110, 112.

Moreover, in several embodiments, a suitable housing 140 may be configured to encase the splice terminal 114, 116 (e.g., a first housing 140 for the first splice terminal 114 and a second housing 140 for the second splice terminal 116), thereby protecting the terminal 114, 116 from adverse weather conditions. For example, as shown in FIG. 4, in one embodiment, the housing 140 may be configured as a two-piece construction including an upper housing component 156 and a lower housing component 158. In such an embodiment, the upper and lower housing components 156, 158 may be configured to be secured to one another using any suitable attachment means and/or method known in the art. For instance, one or more mechanical fasteners (e.g., bolts, screws, pins, brackets and/or the like) and/or other suitable features (e.g., standoffs, snap-fit features, other interlocking features and/or the like) may be used to secure the housing components 156, 158 to one another so as to form an integrated assembly and/or to establish relative positioning between the housing components 156, 158 and/or the splice terminal 114, 116. Alternatively, the upper and lower housing components 156, 158 may be secured to one another using any other suitable means and/or method known in the art, such as by adhering the housing components 156, 158 together using a suitable adhesive.

It should be appreciated that, in alternative embodiments, the housing 140 may have any other suitable configuration that permits it to surround or otherwise encase the disclosed splice terminals 114, 116. For example, in one embodiment, the housing 140 may be formed from a single, integral component, such as by forming an integral hinge (e.g., a living hinge) between the upper and lower housing components 156, 158. In another embodiment, the housing 140 may be formed as a three-piece (or more) assembly.

Additionally, in one embodiment, the housing 140 may be configured to be filled with a suitable filler material 142, thereby providing the splice terminal 114, 116 further protection from adverse weather conditions. For instance, as shown in the cross-sectional view of FIG. 5, the housing may be filled with a filler material 142 such that the filler material 142 completed surrounds the conductors 106, 108, 110, 112 and the splice terminal 114, 116 contained therein. In such an embodiment, it should be appreciated that the filler material 142 may generally comprise any suitable material that may be used to fill the housing 140. For example, in several embodiments, the filler material 142 may comprise a suitable potting material, such as thermo-setting plastics, silicone rubber gels and/or the like, and/or any other suitable material.

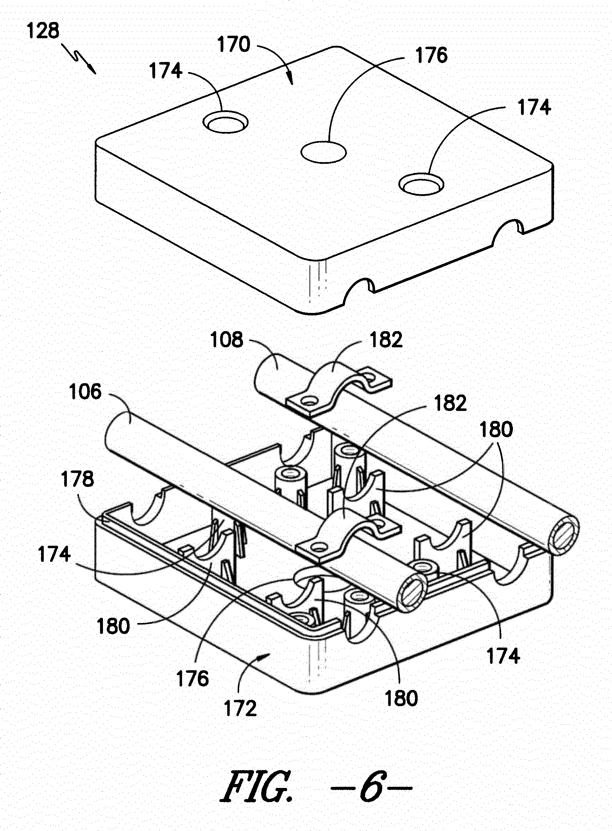

Referring now to FIG. 6, an exploded, perspective view of one embodiment of a suitable configuration for the mounting modules 128 described above with reference to FIGS. 2 and 3 is illustrated in accordance with aspects of the present subject matter. As shown, in several embodiments, the mounting module 128 may generally be configured as an assembly for receiving the positive and negative supply conductors 106, 108 of the supply line 102. Specifically, in one embodiment, the mounting module 128 may include an upper casing component 170 and a lower casing component 172, with the upper and lower casing components 170, 172 being configured to be secured to one another using any suitable attachment means and/or method known in the art. For instance, as shown in FIG. 6, the upper casing component 170 may define one or more openings 174 configured be aligned with one or more corresponding openings 174 defined in the lower casing component 172 when the casing components 170, 172 are brought together. In such an embodiment, one or more suitable mechanical fasteners (e.g., bolts, screws, pins, brackets and/or the like) may be inserted through and/or secured within the aligned openings 174 in order to couple the casing components 170, 172 together. Alternatively, the upper and lower casing components 170, 172 may be secured to one another using any other suitable means and/or method known in the art, such as by adhering the casing components 170, 172 together using a suitable adhesive.

Additionally, in several embodiments, the upper and lower casing components 170, 172 may also define one or more openings 176 configured to receive suitable mechanical fasteners (e.g., bolts, screws, pins, brackets and/or the like) for coupling the mounting module 128 to one of the rails 20, 22 of the racking assembly 14 (e.g., the forward lengthwise rail 126). For instance, as shown in FIG. 6, the upper casing component 170 may define an opening 176 configured be aligned with a corresponding opening 176 defined in the lower casing component 172 when the casing components 170, 172 are brought together. As such, a suitable fastener 130 (FIG. 3) may be inserted through and/or secured within the openings 176 in order to couple the mounting module 128 to the racking assembly 14.

Moreover, in one embodiment, the upper and lower casing components 170, 172 may also include features for aligning the casing components 170, 172 relative to one another For instance, as shown in FIG. 6, the upper casing component 170 may be configured to be positioned over a recessed lip 178 defined around the perimeter of the lower casing component 172. In addition, in several embodiments, the upper and lower casing components 170, 172 may also include features for supporting the supply conductors 106, 108 within the mounting module 128, thereby ensuring that adequate spacing is maintained between the positive supply conductor 106 and the negative supply conductor 108. For example, as shown in the illustrated embodiment, the upper and lower casing components 170, 172 may include projections or standoffs 180 configured to support the supply conductors 106, 108 within the mounting module 128. Further, in several embodiments, at least one of the casing components 170, 172 may include suitable features for coupling the supply conductors106, 108 to the mounting module 128. For instance, as shown in the illustrated embodiment, the lower casing components 172 may be configured to be coupled to the supply conductors 106, 108 via one or more bridge connectors 182 and/or other suitable mechanical fasteners.

It should be appreciated that the mounting module 128 shown in FIG. 6 simply illustrates one example of a suitable configuration for the mounting modules 128 described above with reference to FIGS. 2 and 3. Thus, it should be readily understood by those of ordinary skill in the art that the disclosed mounting modules 128 may have any other suitable configuration that allows them to function as described herein.

It should also be appreciated that, in several embodiments, the present subject matter is directed to a solar farm having a plurality of solar panel arrays 10. Each of the solar panel arrays 10 may include a racking assembly 14 and a plurality of solar panels 12 supported by the racking assembly 14. Each of the solar panels 12 may include a positive output conductor 118 and a negative output conductor 120. In addition, the solar farm may include a supply line 102 extending along a length 32 of each of the solar panel arrays 10. The supply line may 102 include a positive supply conductor 106 and a negative supply conductor 108. The positive output conductor 118 of each of the solar panels 12 may be electrically connected to the positive supply conductor 106 and the negative output conductor 120 of each of the solar panels 12 may be electrically connected to the negative supply conductor 108.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A system for distributing electrical power supplied from a plurality of solar panels (12) supported by a racking assembly (14), the system comprising:
a supply line (102) extending along a length of the racking assembly (14), the supply line including a positive supply conductor (106) and a negative supply conductor (108);
a plurality of mounting modules (128) spaced apart along the length of the racking assembly (14), each of the plurality of mounting modules being configured to receive the positive and negative supply conductors (106, 108);
a positive feed conductor (110) electrically connected to the plurality of solar panels;
a negative feed conductor (112) electrically connected to the plurality of solar panels;
a first splice terminal (114) configured to electrically connect the positive feed conductor to the positive supply conductor; and
a second splice terminal (116) configured to electrically connect the negative feed conductor to the negative supply conductor.

2. The system of claim 1, wherein the positive and negative supply conductors (110, 112) are formed from a different material than the positive and negative feed conductors.

3. The system of claim 2, wherein the positive and negative supply conductors (110, 112) are formed from aluminum and the positive and negative feed conductors are formed from copper.

4. The system of claim 1, 2 or 3, wherein the positive and negative supply conductors (110, 112) have a larger cross-sectional area than the positive and negative feed conductors at the first and second splice terminals.

5. The system of any preceding claim, wherein each of the plurality of solar panels (12) includes a positive output conductor (118) and a negative output conductor (120), the positive feed conductor (110) being electrically connected to the positive output conductor of each of the plurality of solar panels (12) and the negative feed conductor (112) electrically connected to the negative output conductor of each of the plurality of solar panels (12).

6. The system of any preceding claim, wherein the positive supply conductor (106) is spaced apart from the negative supply conductor (108) within each of the plurality of mounting modules.

7. The system of any preceding claim, wherein each of the plurality of mounting modules is configured to be mounted to a rail of the racking assembly.

8. The system of any preceding claim, wherein the first and second splice terminals (114, 116) each comprise a three-way splice terminal.

9. The system of any preceding claim, further comprising a first housing (140) configured to encase the first splice terminal (114) and a second housing (140) configured to encase the second splice terminal (116).

10. The system of claim 9, wherein the first and second housings (140) are filled with a filler material (142).

11. A solar panel array (10), comprising:
a racking assembly (14) including a plurality of lengthwise rails (22) and a plurality of crosswise rails (20);
a plurality of solar panels (12) supported by the racking assembly (14), each of the plurality of solar panels including a positive output conductor (118) and a negative output conductor (120);
the system of any preceding claim, comprising:
a supply line (102) extending along a length of a lengthwise rail (22) of the plurality of lengthwise rails, the supply line including a positive supply conductor (106) and a negative supply conductor (108);
a plurality of mounting modules (128) mounted to the lengthwise rail (22), each of the plurality of mounting modules being configured to receive the positive and negative supply conductors;
a positive feed conductor (110) electrically connected to the positive output conductor of each of the plurality of solar panels;
a negative feed conductor (112) electrically connected to the negative output conductor of each of the plurality of solar panels;
a first splice terminal (114) configured to electrically connect the positive feed conductor to the positive supply conductor; and
a second splice terminal (116) configured to electrically connect the negative feed conductor to the negative supply conductor.

12. The solar panel array of claim 11, wherein the plurality of mounting modules are spaced apart along the length of the lengthwise rail.

13. The solar panel array of claim 11 or claim 12, wherein the positive feed conductor (110) is electrically connected to the positive output conductor (118) of each of the plurality of solar panels at a first common node and the negative feed conductor (112) is electrically connected to the negative output conductor (120) of each of the plurality of solar panels at a second common node.

14. A solar farm, comprising:
a plurality of solar panel arrays (12), each of the plurality of solar panel arrays including a racking assembly (14) and a plurality of solar panels supported by the racking assembly, each of the plurality of solar panels including a positive output conductor (118) and a negative output conductor (120); and
a supply line (102) extending along a length of each of the plurality of solar panel arrays, the supply line including a positive supply conductor (106) and a negative supply conductor (108),
wherein the positive output conductor (118) of each of the plurality of solar panels is electrically connected to the positive supply conductor (106) and the negative output conductor (120) of each of the plurality of solar panels is electrically connected to the negative supply conductor (108).
